Europäisches Patentamt

European Patent Office

Office européen des brevets

(11) Publication number: **0 191 587**
**B1**

## EUROPEAN PATENT SPECIFICATION

(45) Date of publication of patent specification:
09.08.89

(51) Int. Cl.⁴: **H 01 L 29/78**

(21) Application number: 86300743.1

(22) Date of filing: 04.02.86

(54) Charge transfer devices.

(30) Priority: 05.02.85 JP 20684/85

(43) Date of publication of application:
20.08.86 Bulletin 86/34

(45) Publication of the grant of the patent:
09.08.89 Bulletin 89/32

(84) Designated contracting states:
DE FR GB NL

(56) References cited:
GB—A— 2 116 398
PATENTS ABSTRACTS OF JAPAN, vol. 8, no. 59 (E-232) [1496], 17th March 1984 & JP-A-59-210 674
IBM TECHNICAL DISCLOSURE BULLETIN, vol. 16, no. 2, July 1973, page 652, New York, US; K.E. KROELL: "Reduction of the small channel effect in an IGFET structure"

(73) Proprietor: SONY CORPORATION
7-35 Kitashinagawa 6-Chome Shinagawa-ku
Tokyo 141 (JP)

(72) Inventor: Hamasaki, Masaharu Patents Division
Sony Corporation 6-7-35 Kitashinagawa
Shinagawa-ku Tokyo 141 (JP)

(74) Representative: Thomas, Christopher Hugo et al
D Young & Co 10 Staple Inn
London WC1V 7RD (GB)

Jouve, 18, rue St-Denis, 75001 Paris, France

## Description

This invention relates to charge transfer devices using a charge coupled device (CCD).

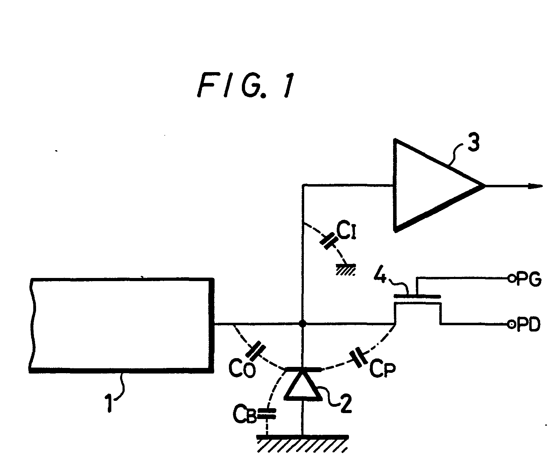

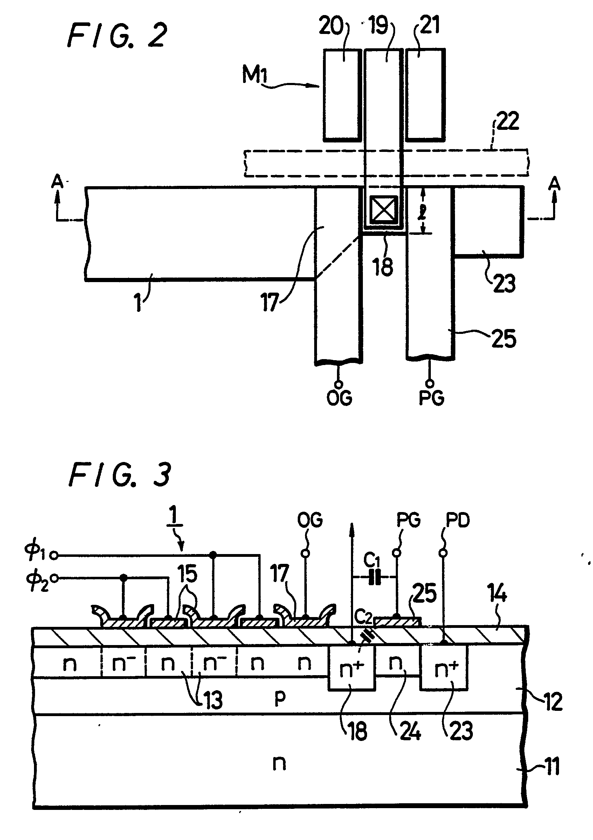

In the output section of a CCD charge transfer device of a solid state imager, a so-called floating diffusion-type amplifier is formed. The circuit diagram of Figure 1 of the accompanying drawings illustrates a previously proposed floating diffusion-type amplifier which is formed such that a signal charge flowing from an output terminal of a CCD transfer section 1 to a diode 2 in a floating diffusion region is obtained as a change of voltage by an output amplifier 3, in other words, at a gate of an MOS transistor M1, as illustrated in Figure 2 of the accompanying drawings. A precharged or socalled reset MOS transistor 4 is connected as illustrated in Figure 1.

Figure 2 is a plan view of the output section, and Figure 3 of the accompanying drawings is a cross-sectional view taken along the line A-A in Figure 2. As illustrated in Figures 2 and 3, a semiconductor substrate 11 of, for example, n type is provided, and a semiconductor well 12 of p type is formed thereon as shown. A plurality of n type regions 13 are formed in the major surface of the semiconductor well 12. On the n type regions 13, there are formed a plurality of transfer electrodes 15 mounted above a gate insulating layer 14 which may be made of $SiO_2$ or other suitable material. This structure forms the CCD transfer section 1 as illustrated.

Two-phase clock pulse signals $\varnothing_1$ and $\varnothing_2$ provide driving pulses which are supplied to the transfer electrodes 15. At the final stage of the CCD transfer section 1, there is provided an output gate portion 17 and a floating diffusion region 18 of $n^+$ type which is formed on the major surface of the semiconductor well 12 adjacent to the output gate portion 17. The floating diffusion region 18 is connected to a gate electrode 19 of the MOS transistor M1 which forms the output amplifier 3. A source region 20 and a drain region 21 of the MOS transistor M1, and a channel stopper region 22 are provided as illustrated in Figure 2. On the major surface of the semiconductor well 12, there is formed a precharge diffusion region 23 of $n^+$ type which is in opposing relationship to the floating diffusion region 18. A channel-forming region 24 of n type is formed on the major surface of the semiconductor well 12 between the regions 18 and 23. On the channelforming region 24, there is formed a precharge gate electrode 25 over the gate insulating layer 14. A precharge terminal PG is provided and a precharge drain terminal PD is also provided, and an output gate terminal OG is also provided which is connected the output gate portion 17.

The output gain of the floating diffusion type amplifier is determined by the floating diffusion region 18, that is the diode 2 and the inherent capacitances CB, CP, CO and CI as illustrated in Figure 1 and Cin. For this case, CB designates the sum of the capacitances between the floating diffusion region 18 and the p type semiconductor well 12, and the capacitance between the floating diffusion region 18 and the channel stopper region 22. CP designates the capacitance between the floating diffusion regin 18 and the precharge gate electrode 25, and CO represents the capacitance between the floating diffusion region 18 and the output gate electrode 17. CI represents the wiring capacitance, and Cin represents the input capacitance of the output amplifier 3 formed within the same semiconductor chip as the CCD transfer section 1.

Therefore, if the voltage gain of the output amplifier 3 is A, an output $V_{OUT}$ which is provided when a signal charge Q enters into the floating diffusion region 18 will be :

$$V_{OUT} = \frac{Q}{CB + CP + CO + CI + Cin} \cdot A \qquad (1)$$

It should be noted that the decrease of the capacitances causes the output gain to increase. As illustrated in Figure 3, the capacitance CP is the sum of a capacitance C1 between the precharge gate electrode 25 and the wiring of the gate electrode 19 of the MOS transistor M1, and the capacitance C2 between the floating diffusion region 18 and the precharge gate electrode 25.

Incidentally, in the structure as illustrated in Figure 2, if the area and peripheral length of the square-shape floating diffusion region 18 are minimized and then the precharge gate electrode 25 is mounted thereon, the contact length 1 between the floating diffusion region 18 and the precharge gate electrode 25 will be equal to the length of one side of the floating diffusion region 18. For this reason, there is a limit to decreasing the capacitance CP.

According to the present invention there is provided a charge transfer device comprising :

an output section which is a floating diffusion type region having sides forming at least one 90 degree corner pointing away from the output gate ; a precharge drain region ; and

a channel region formed between said floating diffusion type region and said precharge drain region ;

characterised in that :

said precharge drain region is formed adjacent to said corner of said floating diffusion type region and is disposed at an angle relative to said sides of said floating diffusion type region ; and

said channel region is formed between said corner and said precharge drain region.

The invention will now be described by way of example with reference to the accompanying drawings, throughout which like parts are referred to by like references, and in which :

Figure 1 is a circuit diagram illustrating an output section which forms a previously proposed floating diffusion-type amplifier ;

Figure 2 is a schematic plan view of an output section of the previously proposed charge transfer device ;

Figure 3 is a sectional view taken on line A-A in Figure 2 ;

Figure 4 is a schematic plan view illustrating an output section of an embodiment of charge transfer device according to the present invention ; and

Figure 5 is a sectional view taken along line B-B in Figure 4.

In the embodiment, as in the example illustrated in Figures 2 and 3, the n type regions 13 are formed on the major surface of the p type semiconductor well 12 which is formed on the semiconductor substrate 11 which is, for example, n type. On the n type regions 13, there are formed a plurality of transfer electrodes 15 above the gate insulating layer 14, which may be made of $SiO_2$, so as to form the CCD transfer section 1.

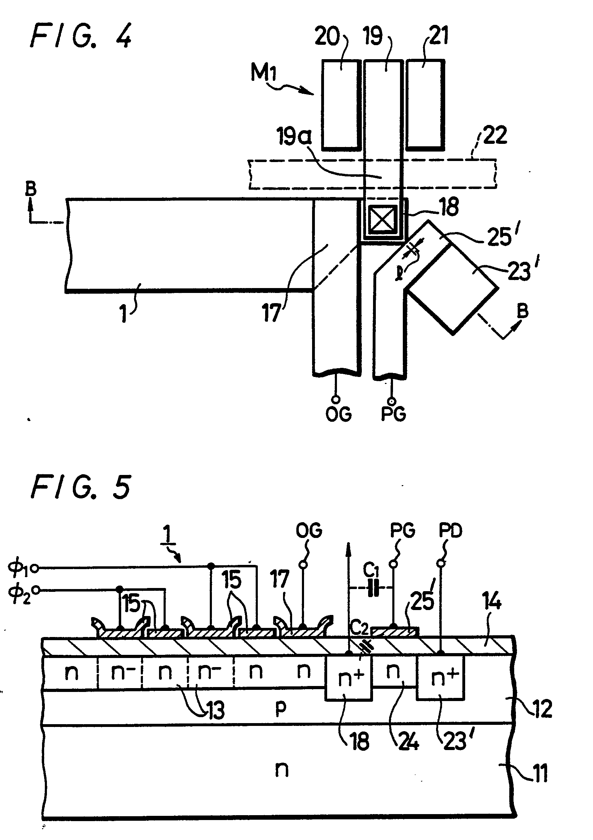

The output gate portion 17 is formed on the gate insulating layer 14 adjacent to the final stage of the CCD transfer section 1. Also, the floating diffusion region 18 of $n^+$ type is formed on the major surface of the semiconductor well 12 adjacent to the output gate portion 17 and the floating diffusion region 18 is connected through an electrical conductor 19a to the gate electrode 19 of the MOS transistor M1 which forms the output amplifier 3 as illustrated in Figure 1. The floating diffusion region 18 is formed to be generally square-shaped in plan view, and the electrical conductor 19a extends parallel to one side of the floating diffusion region 18 as shown. The source region 20 and the drain region 21 of the MOS transistor are formed as illustrated in Figure 4. A channel stopper region 22 is provided, and extends transverse to the source and drain regions 20 and 21.

In the embodiment as illustrated in Figure 4, a precharge drain region 23' of $n^+$ type is formed opposite to the corner of the floating diffusion region 18, such that it is oriented at approximately 45 degrees relative to the floating diffusion region 18. On the n type channel-forming region 24 between the corner portion of the floating diffusion region 18 and the precharge drain region 23' there is formed a precharge gate electrode 25' over the gate insulating layer 14. As shown, the precharge gate electrode 25' is disposed at an angle of, for example, 45 degrees relative to the sides of the floating diffusion region 18, and the electrical conductor 19a which extends from the floating diffusion region 18, so that it is in contact with the corner portion of the floating diffusion region 18 as illustrated.

In the embodiment, since in the output section of the floating diffusion type amplifier, the precharge gate electrode 25' is formed such that the channel is fornned between the corner portion of the floating diffusion region 18 and the precharge drain region 23', the contact length I between the floating diffusion region 18 and the precharge gate electrode 25' is substantially reduced, and also the distance between the precharge gate electrode 25' and the electrical conductor 19a which leads out from the floating diffusion region 18 is increased relative to the previously proposed device. Particularly, when the precharge gate electrode 25' is formed at 45 degrees relative to one side of the floating diffusion region 18, the contact length I will be minimized, and the distance between the precharge gate electrode 25' and the electrical conductor 19a which leads out from the floating diffusion region 18 will become a maximum. Consequently, the area and the surrounding length of the floating diffusion region 18 can be minimized thereby to reduce the capacitance CB, and also the capacitance C2 between the floating diffusion region 18 and the precharge gate electrode 25'. Also, the capacitance C1 between the precharge gate electrode 25' and the electrical conductor 19a of the MOS transistor M1 will be minimized and thus the capacitance CP will be minimized. The output gain of the floating diffusion-type amplifier can therefore be increased and the S/N ratio of the output signal will be improved.

Thus, in the embodiment, the orientation of the precharge drain region 23' is moved to the bias position as, for example, 45 degrees orientation relative to the floating diffusion region 18 as illustrated in Figure 4, and also the precharge gate electrode 25' is moved to take the shape illustrated in Figure 4 to thus result in an improved device.

## Claims

1. A charge transfer device comprising :
an output section which is a floating diffusion type region (18) having sides forming at least one 90 degree corner pointing away from the output gate (17) ;
a precharge drain region (23) ; and
a channel region (24) formed between said floating diffusion type region (18) and said precharge drain region (23) ;
characterised in that :
said precharge drain region (23') is formed adjacent to said corner of said floating diffusion type region (18) and is disposed at an angle relative to said sides of said floating diffusion type region (18) ; and
said channel region (24) is formed between said corner and said precharge drain region (23').

2. A charge transfer delivice according to claim 1 wherein said precharge drain (23') is aligned at substantially 45 degrees to said sides of said floating diffusion type region (18).

3. A charge transfer device according to claim 2 comprising a precharge gate electrode (25') formed between said precharge drain region (23') and said floating diffusion type region (18) and aligned with said precharge drain region (23').

4. A charge transfer device according to claim 3 comprising a channelforming region (24) formed under said precharge gate electrode (25').

5. A charge transfer device according to claim 3 wherein a channel (24) is formed between said corner of said floating diffusion type region (18) and said precharge drain region (23'), and the dimension of said channel (24) normal to charge flow is small.

**Patentansprüche**

1. Ladungsverschiebeanordnung mit

einem Ausgangsabschnitt, der eine potentialfreie (floating) Diffusionszone (18) ist, die Seiten hat, welche eine Ecke mit einem Winkel von zumindest 90° bilden, die von dem Ausgangsgate (17) abgewandt ist,

einer Vorladedrainzone (23) und

einer Kanalzone (24), die zwischen der potentialfreien Diffusionszone (18) und der Vorlade-drainzone (23) ausgebildet ist,

dadurch gekennzeichnet,

daß die Vorladedrainzone (23') in Nachbarschaft der Ecke der potentialfreien Diffusionszone (18) ausgebildet und unter einem Winkel relativ zu den Seiten der potentialfreien Diffusionszone (18) angeordnet ist und

daß die Kanalzone (24) zwischen der Ecke und der Vorladedrainzone (23') ausgebildet ist.

2. Ladungsverschiebeanordnung nach Anspruch 1, bei der die Vorladedrainzone (23') im wesentlichen unter einem Winkel von 45° zu den Seiten der potentialfreien Diffusionszone (18) ausgerichtet angeordnet ist.

3. Ladungsverschiebeanordnung nach Anspruch 2, mit einer Vorladegateelektrode (25'), die zwischen der Vorladedrainzone (23') und der potentialfreien Diffusionszone (18) ausgebildet und mit der Vorladedrainzone (23') ausgerichtet angeordnet ist.

4. Ladungsverschiebeanordnung nach Anspruch 3, mit einer kanalbildenen Zone (24), die unter der Vorladegateelektrode (25') ausgebildet ist.

5. Ladungsverschiebeanordnung nach Anspruch 3, bei der ein Kanal (24) zwischen der Ecke der potentialfreien Diffusionszone (18) und der Vorladedrainzone (23') ausgebildet ist und die Abmessung des Kanals (24) senkrecht zu dem Ladungsfluß klein ist.

**Revendications**

1. Dispositif à transfert de charges, comprenant :

une partie sortie qui est une région du type diffusion flottante (18) ayant des côtés formant au moins un coin à 90 degrés dirigé dans le sens s'éloignant de la grille de sortie (17) ;

une région drain de précharge (23) ; et

une région canal (24) formée entre ladite région du type diffusion flottante (18) et ladite région drain de précharge (23) ;

caractérisé en ce que :

ladite région drain de précharge (23') est formée de manière à être voisine dudit coin de ladite région du type diffusion flottante (18) et est disposée selon un angle par rapport auxdits côtés de ladite région du type diffusion flottante (18) ; et

ladite région canal (24) est formée entre ledit coin et ladite région drain de précharge (23').

2. Dispositif à transfert de charges selon revendication 1, dans lequel ledit drain de précharge (23') est disposé sensiblement à 45 degrés par rapport auxdits côtés de ladite région du type diffusion flottante (18).

3. Dispositif à transfert de charges selon revendication 2, comprenant une électrode de grille de précharge (25') formée entre ladite région de drain de précharge (23') et ladite région du type diffusion flottante (18) et orientée comme ladite région de drain de précharge (23').

4. Dispositif à transfert de charges selon revendication 3, comprenant une région de formation de canal (24), formée en dessous de ladite électrode de grille de précharge (25').

5. Dispositif à transfert de charges selon revendication 3, dans lequel un canal (24) est formé entre ledit coin de ladite région du type diffusion flottante (18) et ladite région de drain de précharge (23'), et la dimension dudit canal (24) est petite normalement à l'écoulement de charges.

# FIG. 1

## FIG. 2

## FIG. 3

## FIG. 4

M1

20  19  21

19a

22

B

18

25'

23'

B

1

17

OG  PG

## FIG. 5

1

OG  PG  PD

$\phi_1$

$\phi_2$

15

15

17

$C_1$

25

14

$C_2$

| n | n⁻ | n | n⁻ | n | n | n⁺ | n | n⁺ |

13  P  12

18  24  23'  11

n